# EUROPÄISCHE PATENTSCHRIFT

(11) **EP 2 580 946 B1**
(45) Veröffentlichungstag und Bekanntmachung des Hinweises auf die Patenterteilung: **08.08.2018**
(21) Anmeldenummer: 11714060.8
(22) Anmeldetag: 13.04.2011
(51) Int. Cl.: H05B 33/08, F21V 23/02, F21V 29/70, F21V 29/74, F21K 9/232, F21K 9/233, F21Y 115/10, F21Y 105/10, H01L 41/04, H01L 41/107, H01L 25/075, F21V 3/00, H01L 33/08, H01L 33/62, H01L 33/64

(54) **LEUCHTDIODENANORDNUNG UND LEUCHTMITTEL INSBESONDERE MIT SOLCH EINER LEUCHTDIODENANORDNUNG**
LIGHT-EMITTING DIODE ARRANGEMENT AND LIGHT-EMITTING MEANS, IN PARTICULAR WITH SUCH A LIGHT-EMITTING DIODE ARRANGEMENT
AGENCEMENT DE DIODE LUMINESCENTE ET ÉLÉMENT LUMINEUX COMPRENANT NOTAMMENT UN TEL AGENCEMENT DE DIODE LUMINESCENTE

(30) Priorität: 10.06.2010 DE 102010023342
(43) Veröffentlichungstag der Anmeldung: 17.04.2013
(73) Patentinhaber: OSRAM Opto Semiconductors GmbH, 93055 Regensburg (DE)
(72) Erfinder: VON MALM, Norwin, 93152 Nittendorf - Thumhausen (DE); MAIWALD, Hubert, 93073 Neutraubling (DE); KRAUS, Robert, 93051 Regensburg (DE); RODE, Patrick, 93059 Regensburg (DE); WIRTH, Ralph, 93138 Lappersdorf (DE)
(74) Vertreter: Epping - Hermann - Fischer
(86) Internationale Anmeldenummer: PCT/EP2011/055848
(87) Internationale Veröffentlichungsnummer: WO 2011/154180

(56) Entgegenhaltungen:
- EP-A2- 1 729 059
- WO-A1-2008/101525
- WO-A1-2009/089529
- WO-A1-2009/101176
- WO-A1-2010/097407
- DE-A1-102006 022 819
- DE-A1-102007 044 567
- US-A1- 2008 024 070
- BISOGNO F. E. ET AL: "A LINE POWER-SUPPLY FOR LED LIGHTING USING PIEZOELECTRIC TRANSFORMERS IN CLASS-E TOPOLOGY", CONFERENCE PROCEEDINGS, IPEMC 2006, CES/IEEE 5TH INTERNATIONAL POWER ELECTRONICS AND MOTION CONTROL CONFERENCE, 14-16 AUG. 2006 SHANGHAI, CHINA, Bd. 2, 14. August 2006 (2006-08-14), Seiten 1117-1121, XP002580166, ISBN: 978-1-4244-0448-3
- GUO MINGSEN ET AL: "A study on the disk-shaped piezoelectric transformer with multiple outputs", REVIEW OF SCIENTIFIC INSTRUMENTS, AIP, MELVILLE, NY, US, Bd. 78, Nr. 12, 7. Dezember 2007 (2007-12-07), Seiten 125103-125103, XP012105577, ISSN: 0034-6748, DOI: 10.1063/1.2818809
- Manh Cuong Do: "Piezoelectric Transformer Integration Possibility in High PowerDensity Applications", TUDpress, Technische Universität Dresden, Dissertation , 2008, Seiten 82-84, XP002664667, Dresden ISBN: 978-3-940046-85-7 Gefunden im Internet: URL:http://www.qucosa.de/fileadmin/data/qu cosa/documents/202/1214984646187-5599.pdf [gefunden am 2011-11-28]
- HU J H ET AL: "A ring-shaped piezoelectric transformer operating in the third symmetric extensional vibration mode", SENSORS AND ACTUATORS A, ELSEVIER SEQUOIA S.A., LAUSANNE, CH, Bd. 88, Nr. 1, 20. Januar 2001 (2001-01-20), Seiten 79-86, XP004228217, ISSN: 0924-4247, DOI: 10.1016/S0924-4247(00)00495-7

## Beschreibung

Es wird eine Leuchtdiodenanordnung angegeben. Darüber hinaus wird ein Leuchtmittel angegeben, das insbesondere eine solche Leuchtdiodenanordnung umfassen kann.

Die Druckschriften Bisogno F. E. et al.: "A Line Power-Supply for LED Lighting using Piezoelectric Transformers in Class-E Topology" (Fraunhofer Institute für Autonome Intelligente Systeme - AIS; 2006 IEEE; pp. 1-5), Mingsen G. et al.: "A study on the disk-shaped piezoelectric transformer with multiple outputs" (Review of Scientific Instruments 78, 2007; pp. 125103-1 - 125103-7) und WO 2009/089529 A1 beschreiben jeweils Leuchtdiodenanordnung und/oder Piezo-Transformatoren.

Die Leuchtdiodenanordnung umfasst einen Piezo-Transformator. Im Vergleich beispielsweise zu einem magnetisch arbeitenden Transformator zeichnet sich ein Piezo-Transformator durch seine hohe Effizienz und sein kleines Volumen aus. Der Piezo-Transformator enthält oder besteht aus wenigstens einem keramischen Material. Insbesondere kann der Piezo-Transformator als keramisches Material ein Blei-Zirkonat-Titanat (PZT) enthalten. Ferner ist es möglich, dass der Piezo-Transformator frei von Schwermetallen ist. Piezo-Transformatoren sind beispielsweise in den Druckschriften DK 176870 B1 und US 2007/0024254 A1 beschrieben, deren Offenbarungsgehalt hiermit ausdrücklich durch Rückbezug aufgenommen ist.

Die Erfindung betrifft eine Leuchtdiodenanordnung gemäß der unabhängigen Ansprüche 1 und 5 sowie ein Leuchtmittel gemäß Anspruch 6.

Der Piezo-Transformator weist zumindest eine ausgangseitige Anschlussstelle auf. An der ausgangseitigen Anschlussstelle stellt der Piezo-Transformator elektrischen Strom und Spannung zum Betreiben eines an die ausgangseitige Anschlussstelle anzuschließenden Bauelements zur Verfügung. Der Piezo-Transformator kann dabei mehr als eine ausgangseitige Anschlussstelle umfassen.

Die Leuchtdiodenanordnung umfasst eine Hochvolt-Leuchtdiode, die einen Hochvolt-Leuchtdiodenchip umfasst. Bei einem Hochvolt-Leuchtdiodenchip handelt es sich vorliegend um einen Leuchtdiodenchip, der zumindest zwei aktive Bereiche umfasst, die zueinander in Reihe geschaltet sind. Jeder der aktiven Bereiche ist dabei im Betrieb des Hochvolt-Leuchtdiodenchips zur Erzeugung von elektromagnetischer Strahlung vorgesehen. Der Hochvolt-Leuchtdiodenchip kann dabei zwei oder mehr aktive Bereiche umfassen, die zueinander in Reihe geschaltet sind. Zum Beispiel umfasst der Hochvolt-Leuchtdiodenchip zehn oder mehr aktive Bereiche, die zueinander in Reihe geschaltet sind. Die aktiven Bereiche können vertikal übereinander gestapelt und/oder lateral nebeneinander angeordnet sein.

Die Hochvolt-Leuchtdiode ist elektrisch an die ausgangseitige Anschlussstelle des Piezo-Transformators angeschlossen. Das heißt, über die ausgangseitige Anschlussstelle des Piezo-Transformators wird die Hochvolt-Leuchtdiode vom Piezo-Transformator mit Strom und Spannung versorgt.

Die Hochvolt-Leuchtdiode kann dabei aus dem Hochvolt-Leuchtdiodenchip bestehen oder den Hochvolt-Leuchtdiodenchip enthalten. Enthält die Hochvolt-Leuchtdiode den Hochvolt-Leuchtdiodenchip, so kann die Hochvolt-Leuchtdiode neben dem Hochvolt-Leuchtdiodenchip weitere Komponenten, wie beispielsweise weitere (Hochvolt)-Leuchtdiodenchips, ESD-Schutzkomponenten, Gehäusekomponenten und ähnliches umfassen.

Die Leuchtdiodenanordnung umfasst einen Piezo-Transformator, der zumindest eine ausgangseitige Anschlussstelle aufweist und eine Hochvolt-Leuchtdiode, die einen Hochvolt-Leuchtdiodenchip umfasst. Die Hochvolt-Leuchtdiode ist dabei elektrisch an die ausgangseitige Anschlussstelle des Piezo-Transformators angeschlossen und der Hochvolt-Leuchtdiodenchip umfasst zumindest zwei aktive Bereiche, die zueinander in Reihe geschaltet sind.

Der hier beschriebenen Leuchtdiodenanordnung liegt dabei unter anderem die Erkenntnis zugrunde, dass bei der Verwendung einer Hochvolt-Leuchtdiode, an der im Vergleich zu einer herkömmlichen Leuchtdiode relativ viel Spannung im Betrieb abfällt, ein Effizienzvorteil gegenüber der Verwendung herkömmlicher Leuchtdioden erreicht werden kann, der sich aus der kleineren Spannungsdifferenz zwischen der Netzspannung, die eingangseitig am Piezo-Transformator anliegt, und der Hochvolt-Leuchtdiodenbetriebsspannung ergibt. Ferner ergibt sich durch die Verwendung eines Piezo-Transformators ein Platzvorteil, da die Leuchtdiodenanordnung aufgrund des relativ geringen Volumens des Piezo-Transformators im Vergleich zu einem magnetisch arbeitenden Transformator die Leuchtdiodenanordnung besonders klein ausgeführt werden kann.

Gemäß zumindest einer Ausführungsform der Leuchtdiodenanordnung fällt am Hochvolt-Leuchtdiodenchip der Hochvolt-Leuchtdiode eine Spannung von wenigstens 4 V ab. Beispielsweise fällt am Hochvolt-Leuchtdiodenchip eine Spannung von 10, 12, 24, 90, 110 oder 230 Volt ab. Der Hochvolt-Leuchtdiodenchip kann also mit einer relativ hohen Spannung von wenigstens 4 V betrieben werden.

Gemäß zumindest einer Ausführungsform der Leuchtdiodenanordnung weist der Piezo-Transformator wenigstens zwei ausgangseitige Anschlussstellen auf, wobei an jede ausgangseitige Anschlussstelle eine Hochvolt-Leuchtdiode mit einem Hochvolt-Leuchtdiodenchip elektrisch angeschlossen ist. Dabei umfasst jeder Hochvolt-Leuchtdiodenchip zumindest zwei aktive Bereiche, die zueinander in Reihe geschaltet sind. Das heißt, vom Piezo-Transformator werden über unterschiedliche ausgangseitige Anschlussstellen unterschiedliche Hochvolt-Leuchtdioden mit Betriebsstrom und Spannung versorgt.

Gemäß zumindest einer Ausführungsform der Leuchtdiodenanordnung umfasst zumindest eine der Hochvolt-Leuchtdioden mehr als einen Hochvolt-Leuchtdiodenchip, wobei jeder Hochvolt-Leuchtdiodenchip zumindest zwei aktive Bereiche umfasst, die zueinander in Reihe geschaltet sind. Die Hochvolt-Leuchtdiodenchips können sich dabei durch ihre optischen und elektrischen Eigenschaften voneinander unterscheiden. Beispielsweise können sich die Hochvolt-Leuchtdiodenchips in ihrer Spannungsaufnahme voneinander unterscheiden. Ferner können die Hochvolt-Leuchtdiodenchips elektromagnetische Strahlung mit voneinander unterschiedlichen Wellenlängen emittieren. Insbesondere sind Kombinationen aus blaues Licht, weißes Licht, mintfarbenes Licht, rotes Licht, warmweißes Licht und/oder kaltweißes Licht emittierenden Hochvolt-Leuchtdiodenchips möglich. Die unterschiedlichen Hochvolt-Leuchtdiodenchips können fest miteinander verdrahtet sein oder durch variable Steuerelemente wie zum Beispiel Schalter, Transistoren, Potenziometer, Fotowiderstände oder temperaturabhängige Widerstände mit unterschiedlichen Strömen versorgt werden. Ferner können die unterschiedlichen Hochvolt-Leuchtdiodenchips auch mit unterschiedlichen Ausgängen des Piezo-Transformators verbunden sein, die unterschiedliche Spannungen und Maximalströme zur Verfügung stellen können. In diesem Fall ist es insbesondere möglich, dass die Hochvolt-Leuchtdioden durch Hochvolt-Leuchtdiodenchips gebildet sind.

Gemäß zumindest einer Ausführungsform der Leuchtdiodenanordnung ist an zumindest einer der ausgangseitigen Anschlussstellen des Piezo-Transformators mehr als eine Hochvolt-Leuchtdiode angeschlossen. Die Hochvolt-Leuchtdioden, die an einem Ausgang des Piezo-Transformators angeschlossen sind, können beispielsweise zueinander in Reihe, parallel zueinander oder in Kombinationen von Reihen- und Parallelschaltung miteinander verdrahtet sein.

Wieder ist es möglich, dass die Hochvolt-Leuchtdioden dabei wenigstens einen Hochvolt-Leuchtdiodenchip umfassen oder aus einem Hochvolt-Leuchtdiodenchip jeweils bestehen.

Gemäß zumindest einer Ausführungsform der Leuchtdiodenanordnung ist zumindest eine der Hochvolt-Leuchtdioden oder zumindest einer der Hochvolt-Leuchtdiodenchip mit Wechselspannung betreibbar. Ein mit Wechselspannung betreibbarer Hochvolt-Leuchtdiodenchip kann beispielsweise dadurch erreicht sein, dass eine erste Gruppe von aktiven Bereichen des Hochvolt-Leuchtdiodenchips zueinander in Reihe geschaltet ist und dass eine zweite Gruppe von aktiven Bereichen des Hochvolt-Leuchtdiodenchips zueinander in Reihe geschaltet ist, wobei die erste Gruppe zur zweiten Gruppe antiparallel geschaltet ist. Neben einer antiparallelen Verschaltung der aktiven Bereiche des Hochvolt-Leuchtdiodenchips ist auch die Verschaltung in einer Wheatstone'schen Brückengleichrichter-Schaltung möglich.

Für den Fall, dass es sich um eine Hochvolt-Leuchtdiode handelt, die mit Wechselspannung betreibbar ist, kann die Hochvolt-Leuchtdiode mehrere in Reihe und antiparallel zueinander geschaltete Hochvolt-Leuchtdiodenchips umfassen. Ferner ist es möglich, dass die Hochvolt-Leuchtdiode einen Hochvolt-Leuchtdiodenchip und einen in die Leuchtdiode integrierten Gleichrichter umfasst.

Sind die Hochvolt-Leuchtdioden oder die Hochvolt-Leuchtdiodenchips der Leuchtdiodenanordnung nicht mit Wechselspannung betreibbar, so umfasst die Leuchtdiodenanordnung vorzugsweise wenigstens einen Gleichrichter, der dem Piezo-Transformator vor- oder nachgeschaltet sein kann. Ferner können weitere elektronische Komponenten zur Glättung und/oder Leistungsfaktor-Verbesserung in der Leuchtdiodenanordnung vorhanden und mit dem Piezo-Transformator und/oder der Hochvolt-Leuchtdiode verbunden sein.

Gemäß zumindest einer Ausführungsform der Leuchtdiodenanordnung stellt jede der ausgangseitigen Anschlussstellen des Piezo-Transformators eine vorgebbare Ausgangsspannung und einen vorgebbaren maximalen Ausgangsstrom bereit. Das heißt insbesondere, dass der Ausgangsstrom, der vom Piezo-Transformator zur Verfügung gestellt wird, begrenzt ist. Bei der Strombegrenzung handelt es sich um eine inhärente Eigenschaft eines Piezo-Transformators. Die Ansteuerung der Hochvolt-Leuchtdiode der Leuchtdiodenanordnung kann daher spannungsgetrieben erfolgen, ohne dass sich zu hohe Schwankungen oder Spitzen in der Stromstärke für die Hochvolt-Leuchtdiode ergeben. Durch die spannungsgetriebene Ansteuerung ergibt sich eine sehr einfache und daher preiswerte Gestaltung eines Treibers der Leuchtdiodenanordnung, insbesondere kann auf eine aufwändige Konstantstromelektronik als Treiber verzichtet werden. Ferner ergibt sich durch die Strombegrenzung des Piezo-Transformators eine reduzierte Alterung der Hochvolt-Leuchtdioden, da zu hohen Spitzenströmen durch die Verwendung des Piezo-Transformators vorgebeugt ist.

Gemäß zumindest einer Ausführungsform der Leuchtdiodenanordnung unterscheiden sich die Ausgangsspannung und/oder der maximale Ausgangsstrom von zwei unterschiedlichen ausgangseitigen Anschlussstellen voneinander. Im Extremfall kann der Piezo-Transformator an jeder ausgangseitigen Anschlussstelle einen Ausgangsstrom und/oder eine Ausgangsspannung zur Verfügung stellen, die sich vom Ausgangsstrom und/oder der Ausgangsspannung der restlichen ausgangseitigen Anschlussstellen des Piezo-Transformators unterscheidet. Auf diese Weise ist insbesondere die Verwendung von verschiedenfarbigen Hochvolt-Leuchtdioden an unterschiedlichen ausgangseitigen Anschlussstellen des Piezo-Transformators besonders einfach, so dass die Leuchtdiodenanordnung Licht in einem besonders großen Farbraum erzeugen kann.

Der Piezo-Transformators ist rahmenartig ausgebildet, wobei der Piezo-Transformator zumindest eine der Hochvolt-Leuchtdioden seitlich umschließt. Da der Piezo-Transformator mit einem keramischen Material gebildet ist, sind unterschiedlichste Formgebungen für den Piezo-Transformator möglich. Insbesondere ist es möglich, dass der Piezo-Transformator einen Durchbruch aufweist. Der Piezo-Transformator ist dann rahmenartig oder als Rahmen ausgebildet, in dem Sinne, dass ein Durchbruch im Piezo-Transformator in lateraler Richtung vom Material des Piezo-Transformators umschlossen ist. Die Hochvolt-Leuchtdioden der Leuchtdiodenanordnung können in diesem Durchbruch angeordnet werden, so dass die Hochvolt-Leuchtdioden der Leuchtdiodenanordnung oder zumindest eine Hochvolt-Leuchtdiode der Leuchtdiodenanordnung seitlich vom Piezo-Transformator umschlossen ist.

Vorteilhaft kann zumindest eine Leuchtdiode der Leuchtdiodenanordnung so direkt auf einem Anschlussträger oder einem Kühlkörper befestigt werden, auf dem ebenfalls der rahmenartig ausgebildete Piezo-Transformator angeordnet ist. Der Piezo-Transformator ist in diesem Fall nicht zwischen dem Anschlussträger, dem Kühlkörper und der Hochvolt-Leuchtdiode angeordnet, sondern er umgibt die Hochvolt-Leuchtdiode seitlich. Im Betrieb von der Hochvolt-Leuchtdiode erzeugte Wärme muss also nicht durch den Piezo-Transformator abgeführt werden, um beispielsweise zum Kühlkörper zu gelangen.

Gemäß zumindest einer Ausführungsform der Leuchtdiodenanordnung umfasst die Leuchtdiodenanordnung einen Anschlussträger, der eine Montagefläche aufweist. Bei dem Anschlussträger handelt es sich beispielsweise um eine Leiterplatte, wie eine bedruckte Leiterplatte oder eine Metallkernplatine. Der Anschlussträger umfasst beispielsweise einen elektrisch isolierenden Grundkörper. In und/oder auf den isolierenden Grundkörper sind Leiterbahnen und/oder elektrische Kontaktstellen strukturiert. Die Leuchtdiodenanordnung umfasst ferner in dieser Ausführungsform zumindest eine Hochvolt-Leuchtdiode, die an der Montagefläche des Anschlussträgers befestigt und elektrisch leitend mit dem Anschlussträger verbunden ist. Der Piezo-Transformator ist ebenfalls mit dem Anschlussträger elektrisch leitend verbunden und die zumindest eine Hochvolt-Leuchtdiode ist über den Anschlussträger an die ausgangseitige Anschlussstelle des Piezo-Transformators angeschlossen. Das heißt, die elektrische Verbindung zwischen der zumindest einen Hochvolt-Leuchtdiode der Leuchtdiodenanordnung und dem Piezo-Transformator erfolgt über den Anschlussträger.

Gemäß zumindest einer Ausführungsform der Leuchtdiodenanordnung umfasst die Leuchtdiodenanordnung ein Mittel zur mechanischen Entkopplung. Das Mittel zur mechanischen Entkopplung ist zischen dem Piezo-Transformator und dem Anschlussträger und/oder dem Kühlkörper angeordnet und befindet sich mit den genannten Komponenten zum Beispiel in direktem Kontakt. Das Mittel zur mechanischen Entkopplung umfasst zum Beispiel ein elastisches oder federndes Material. Das Mittel zur mechanischen Entkopplung behindert die Übertragung von Schwingungen des Piezo-Transformators, die während dessen Betrieb auftreten, auf zum Piezo-Transformator benachbarte Komponenten.

Es wird ferner ein Leuchtmittel angegeben. Das Leuchtmittel umfasst zumindest eine Leuchtdiodenanordnung, die einen Piezo-Transformator, der zumindest eine eingangseitige Anschlussstelle und zumindest eine ausgangseitige Anschlussstelle aufweist und eine Leuchtdiode, die einen Leuchtdiodenchip umfasst, aufweist. Bei der Leuchtdiode und dem Leuchtdiodenchip handelt es sich um eine Hochvolt-Leuchtdiode und einen Hochvolt-Leuchtdiodenchip wie sie oben beschrieben sind.

Insbesondere handelt es sich bei der Leuchtdiodenanordnung um eine hier beschriebene Leuchtdiodenanordnung handeln, die eine Hochvolt-Leuchtdiode mit einem Hochvolt-Leuchtdiodenchip umfasst. Das heißt, sämtliche für die Leuchtdiodenanordnung offenbarten Merkmale sind auch für das Leuchtmittel offenbart und umgekehrt.

Gemäß zumindest einer Ausführungsform des Leuchtmittels umfasst das Leuchtmittel einen Gehäusekörper, der ein Volumen umschließt, in dem die Leuchtdiodenanordnung vollständig angeordnet ist. Der Gehäusekörper dient beispielsweise dazu, die Leuchtdiodenanordnung vor Berührung und anderen mechanischen Einwirkungen zu schützen. Der Gehäusekörper ist beispielsweise mit einem Metall und/oder einem Kunststoff und/oder einem Glas und/oder einem keramischen Material gebildet.

Gemäß zumindest einer Ausführungsform umfasst das Leuchtmittel ferner einen Sockel, der zumindest einen Sockelkontakt umfasst. Bei dem Leuchtmittel handelt es sich vorzugsweise um ein so genanntes "Retrofit". Das heißt, aufgrund der Ausbildung des Sockels kann das Leuchtmittel anstelle herkömmlicher Glühlampen oder Halogenlampen Verwendung finden. Je nachdem, wo das Leuchtmittel als Retrofit Verwendung finden soll, kann der Sockel als Schraubsockel, Röhrensockel, Stecksockel, Stiftsockel oder ähnliches ausgeführt sein. Das Leuchtmittel ist dabei nicht auf eine bestimmte Anzahl, Betriebsspannung, Emissionsfarbe und/oder Verschaltung der Leuchtdioden des Leuchtmittels beschränkt. Das Leuchtmittel ist besonders variabel und für verschiedene Leistungsklassen, beispielsweise bis zirka 50 W Leistungsaufnahme, sowie beliebige Abstrahlprofile wie "Downlight", "Spotlight", und "Omnidirectional" geeignet.

Über den zumindest einen Sockelkontakt, typischerweise zumindest zwei Sockelkontakte, wird die Leuchtdiodenanordnung des Leuchtmittels von außerhalb des Leuchtmittels mit elektrischem Strom versorgt.

Gemäß zumindest einer Ausführungsform des Leuchtmittels ist die Leuchtdiode elektrisch an die ausgangseitige Anschlussstelle des Piezo-Transformators angeschlossen und die zumindest eine eingangseitige Anschlussstelle des Piezo-Transformators ist mit dem zumindest einem Sockelkontakt elektrisch leitend verbunden.

Gemäß zumindest einer Ausführungsform umfasst das Leuchtmittel zumindest eine Leuchtdiodenanordnung mit einem Piezo-Transformator, der zumindest eine eingangseitige Anschlussstelle und zumindest eine ausgangseitige Anschlussstelle aufweist und mit einer Leuchtdiode, die einen Leuchtdiodenchip umfasst. Ferner umfasst das Leuchtmittel einen Gehäusekörper, der ein Volumen umschließt, in dem die Leuchtdiodenanordnung vollständig angeordnet ist, einen Sockel, der zumindest einen Sockelkontakt umfasst, wobei die Leuchtdiode elektrisch an die ausgangseitige Anschlussstelle des Piezo-Transformator angeschlossen ist und die zumindest eine eingangseitige Anschlussstelle des Piezo-Transformators mit dem zumindest einen Sockelkontakt elektrisch leitend verbunden ist.

Durch die Verwendung des Piezo-Transformators im Leuchtmittel, der sich insbesondere durch sein kleines Volumen auszeichnet, steht im Leuchtmittel beispielsweise besonders viel Platz für die Leuchtdiodenanordnung und damit die lichterzeugende Komponente des Leuchtmittels zur Verfügung. Ferner ergibt sich durch den Piezo-Transformator eine galvanischen Trennung. Dies erlaubt es, eine zweite Isolation des Anschlussträgers der Leuchtdiodenanordnung zum Gehäusekörper hin einzusparen oder eine Isolation dünner auszuführen.

Gemäß zumindest einer Ausführungsform des Leuchtmittels umfasst das Leuchtmittel einen Kühlkörper, der thermisch leitend mit der zumindest einen Leuchtdiodenanordnung verbunden ist, wobei der Kühlkörper vollständig im vom Gehäusekörper umschlossenen Volumen angeordnet ist. Der Kühlkörper nimmt dabei wenigstens 20 % des Volumens, das vom Gehäusekörper umschlossen ist, ein. Vorzugsweise füllt der Kühlkörper wenigstens 30 %, besonders bevorzugt wenigstens 40 % des Volumens aus. Dies ist dadurch ermöglicht, dass vorliegend ein Piezo-Transformator Verwendung findet, der sich durch sein gegenüber einem magnetisch arbeitenden Transformator reduziertes Volumen auszeichnet. Auf diese Weise ist es möglich, dass beispielsweise Kühlrippen des Kühlkörpers weit in das vom Gehäusekörper umschlossene Volumen hineinragen und somit eine besonders große Kühlfläche des Kühlkörpers und eine daraus resultierende besonders gute Kühlung durch den Kühlkörper erreicht ist. Ferner bietet das größere zur Verfügung stehende Volumen des Kühlkörpers auch mehr Freiheiten beim Design des Kühlkörpers, was eine besonders variable Gestaltung des Leuchtmittels erlaubt. Durch die gesteigerte Wärmeabfuhr am Kühlkörper verbessern sich bei gegebenem Lichtstrom auch die Effizienz und die Betriebsdauer der Leuchtdioden und der Treiberschaltung für die Leuchtdioden.

Um den Piezo-Transformator in das Leuchtmittel zu integrieren, wird vorzugsweise eine Frequenz-gebende Transistorschaltung eingesetzt. Zur Erhaltung der maximalen Effizienz des Piezo-Transformators bei schwankenden Temperaturen, beispielsweise aufgrund der Abwärme der Leuchtdioden des Leuchtmittels, kann an eine oder alle ausgangseitigen Anschlussstellen des Piezo-Transformators ein Feedback-Element verbunden sein, welches der Transistorschaltung zur Optimierung der Betriebsfrequenz die Ausgangsleistung des Piezo-Transformators rückkoppelt.

Im Folgenden werden die hier beschriebene Leuchtdiodenanordnung sowie das hier beschriebene Leuchtmittel anhand von Ausführungsbeispielen und den dazugehörigen Figuren näher erläutert.
Die Figuren 1A, 1B, 2A, 2B, 3A, 3B zeigen schematische Ansichten von hier beschriebenen Leuchtdiodenanordnungen.
Die Figuren 4A, 4B und 5 zeigen schematische Ansichten von hier beschriebenen Leuchtmitteln.
Die Figuren 6 und 7 zeigen schematische Ansichten von Hochvolt-Leuchtdiodenchips, wie sie vorliegend zum Einsatz kommen können.
Die Figur 8 zeigt eine schematische Schaltskizze einer hier beschriebenen Leuchtdiodenanordnung.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

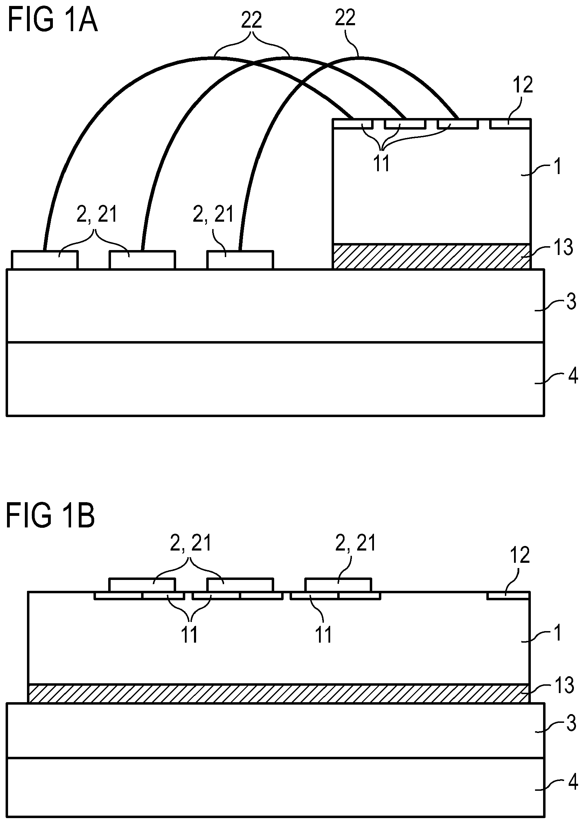

Die Figur 1A zeigt anhand einer schematischen Schnittdarstellung ein Beispiel einer hier beschriebenen Leuchtdiodenanordnung, das nicht Teil der Erfindung ist. Die Leuchtdiodenanordnung umfasst einen Piezo-Transformator 1, der beispielsweise mit einem keramischen Material gebildet ist. Der Piezo-Transformator 1 umfasst ausgangseitige Anschlussstellen 11 sowie zumindest eine eingangseitige Anschlussstelle 12.

Weiter umfasst die Leuchtdiodenanordnung einen Anschlussträger 3, bei dem es sich beispielsweise um eine Leiterplatte oder eine Metallkernplatine handelt. Der Piezo-Transformator 1 ist an einer Montagefläche 3a am Anschlussträger 3 befestigt. Dabei ist zwischen Piezo-Transformator 1 und Anschlussträger 3 ein Mittel zur mechanischen Entkopplung 13 angeordnet. Das Mittel zur mechanischen Entkopplung 13 umfasst zum Beispiel ein elastisches oder federndes Material. Das Mittel zur mechanischen Entkopplung 13 behindert die Übertragung von Schwingungen des Piezo-Transformators 1, die während dessen Betrieb auftreten, auf den Anschlussträger 3.

Die mechanische Entkopplung 13 ist zum Beispiel mit einem synthetischen Gummi, Kautschuk, einem Elastomer, einem Thermoplast oder einem elektrisch isolierten Metall in Form einer Feder gebildet.

An dem Anschlussträger 3 sind auf der Montagefläche 3a ferner die Hochvolt-Leuchtdioden 2 angeordnet. Jede Hochvolt-Leuchtdiode 2 kann aus einem Hochvolt-Leuchtdiodenchip 21 bestehen oder zumindest einen Hochvolt-Leuchtdiodenchip 21 enthalten.

Der vom Piezo-Transformator im Betrieb bereitgestellte Strom wird zum Beispiel über Bonddrähte 22 zu den Hochvolt-Leuchtdioden 2 geleitet. Dabei kann an jeder ausgangseitigen Anschlussstelle 11 genau eine Hochvolt-Leuchtdiode 2 mit dem Piezo-Transformator verbunden sein. Ferner ist es möglich, dass an einer ausgangseitigen Anschlussstelle 11 mehrere Hochvolt-Leuchtdioden 2 angeschlossen sind.

Die Leuchtdiodenanordnung 7 umfasst ferner einen Kühlkörper 4, der beispielsweise aus einem Metall wie Kupfer besteht oder ein Metall enthält. Der Kühlkörper 4 ist an der dem Piezo-Transformator 1 abgewandten Seite des Anschlussträgers 3 angeordnet.

Im Unterschied zum Beispiel der Figur 1A sind im Beispiel, das in Verbindung mit der Figur 1B beschrieben ist und das ebenfalls nicht Bestandteilt der Erfindung ist, die Hochvolt-Leuchtdioden 2, die je zumindest einen Hochvolt-Leuchtdiodenchip 21 umfassen oder aus einem Hochvolt-Leuchtdiodenchip 21 bestehen, an der dem Anschlussträger 3 abgewandten Seite des Piezo-Transformators 1 befestig und elektrisch angeschlossen.

Nachteilig kann es sich beim Ausführungsbeispiel der Figur 1B erweisen, dass von den Hochvolt-Leuchtdiodenchips 2 im Betrieb erzeugte Wärme durch den Piezo-Transformator 1 treten muss, um zum Kühlkörper 4 zu gelangen.

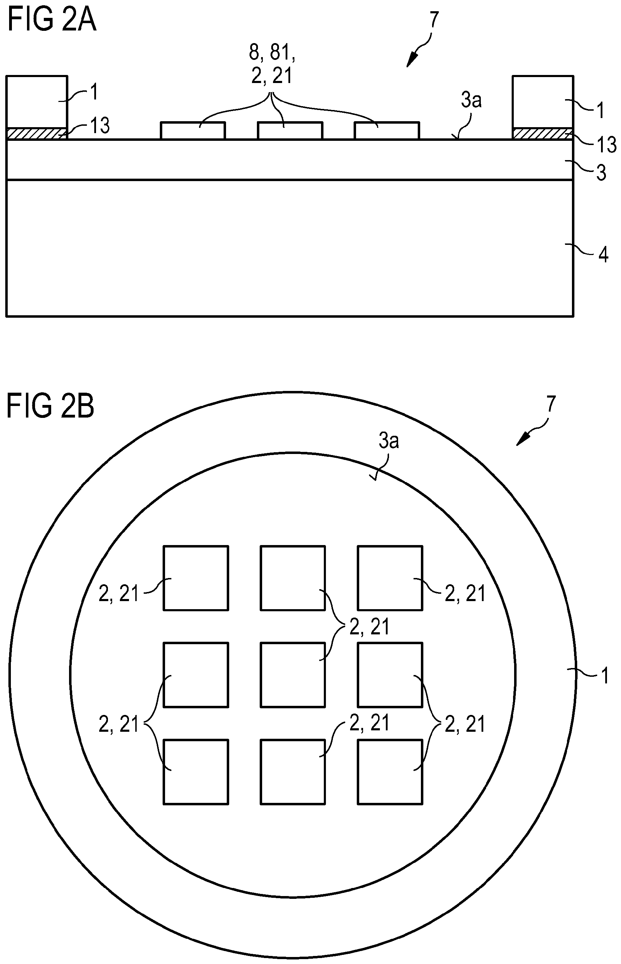

In Verbindung mit der schematischen Schnittdarstellung der Figur 2A und der schematischen Draufsicht der Figur 2B ist ein erstes Ausführungsbeispiel der hier beschriebenen Leuchtdiodenanordnung 7 näher erläutert. In diesem Ausführungsbeispiel ist der Piezo-Transformator 1 rahmenartig, vorliegend als Ring ausgebildet. Der Piezo-Transformator 1 ist ebenfalls, das heißt genauso wie die Hochvolt-Leuchtdioden 2, an der Montagefläche 3a des Anschlussträgers 3 befestigt und dort elektrisch mit dem Anschlussträger 3 und über den Anschlussträger 3 mit den Hochvolt-Leuchtdioden 2 verbunden. Zwischen Piezo-Transformator 1 und Anschlussträger 3 ist das Mittel zur mechanischen Entkopplung 13 angeordnet. An der dem Hochvolt-Leuchtdioden 2 und dem Piezo-Transformator abgewandten Seite des Anschlussträgers 3 ist der Kühlkörper 4 angeordnet. Das heißt, von den Hochvolt-Leuchtdioden 2 im Betrieb erzeugte Wärme muss nicht durch den Piezo-Transformator treten, um zum Kühlkörper 4 zu gelangen. Darüber hinaus umgibt der Piezo-Transformator 1 die Hochvolt-Leuchtdioden 2 seitlich und stellt auf diese Weise einen mechanischen Schutz für die Hochvolt-Leuchtdioden 2 dar.

Der Piezo-Transformator umfasst also eine Ausnehmung, die rahmenartig durch das Material des Piezo-Transformators 1 umgeben ist. In dieser Ausnehmung oder in diesem Durchbruch sind die Hochvolt-Leuchtdioden 2 auf dem Anschlussträger 3 angeordnet. Dabei ist es auch möglich, dass die Hochvolt-Leuchtdioden 2 direkt auf den Kühlkörper 4 aufgebracht sind, das heißt dass der Kühlkörper 4 auch die Aufgaben des Anschlussträgers 3 übernimmt.

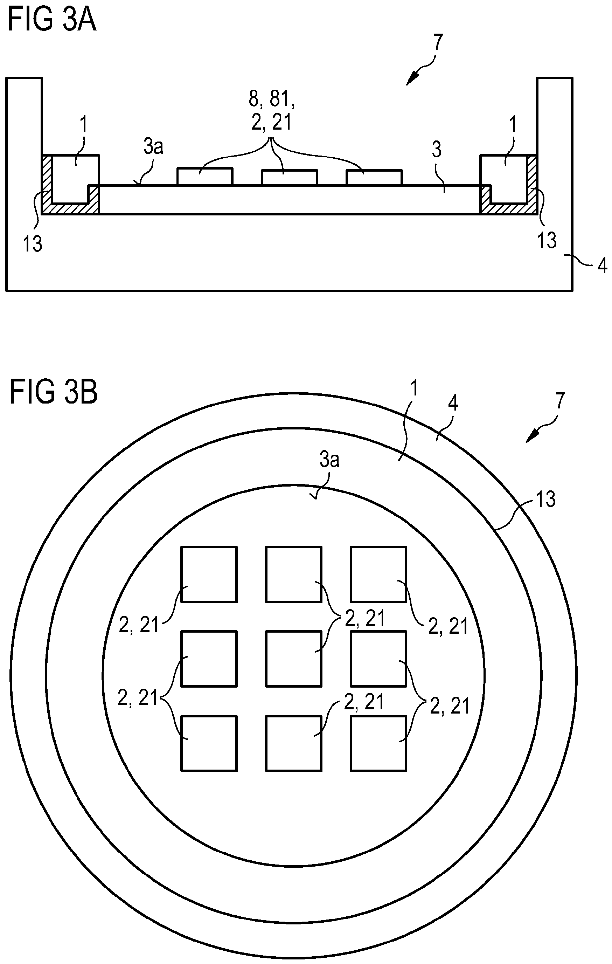

In Verbindung mit der schematischen Schnittdarstellung der Figur 3A und der schematischen Draufsicht der Figur 3B ist ein weiteres Ausführungsbeispiel der hier beschriebenen Leuchtdiodenanordnung 7 näher erläutert. In diesem Ausführungsbeispiel ist der Piezo-Transformator 1 im Unterschied zum Ausführungsbeispiel der Figuren 2A, 2B derart angeordnet, dass er auch den Anschlussträger 3 rahmenartig seitlich umgibt. Der Piezo-Transformator selbst kann an zumindest zwei Seiten vom Kühlkörper 4 umschlossen sein, was zu einer verbesserten Wärmeabfuhr vom Piezo-Transformator 1 führt. Zwischen Piezo-Transformator 1, Anschlussträger 3 und Kühlkörper 14 ist das Mittel zur mechanischen Entkopplung 13 angeordnet.

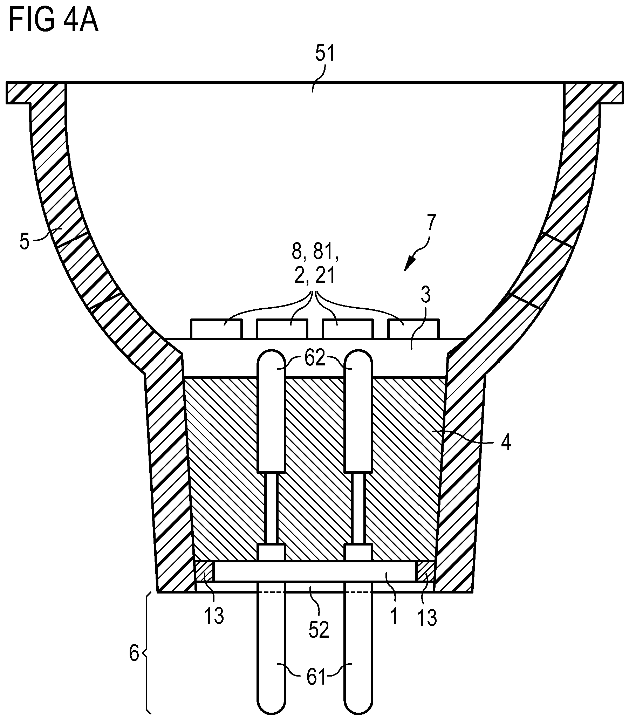

In Verbindung mit der schematischen Schnittdarstellung der Figur 4A ist ein Beispiel eines hier beschriebenen Leuchtmittels näher erläutert, das nicht Teil der Erfindung ist. Das Leuchtmittel weist eine Leuchtdiodenanordnung 7 auf, die beispielsweise wie in Verbindung mit den Figuren 1 bis 3 angegeben, ausgeführt sein kann. Die Leuchtdiodenanordnung 7 kann Hochvolt-Leuchtdioden 2 mit Hochvolt-Leuchtdiodenchips 21 und/oder herkömmliche Leuchtdioden 8 mit herkömmlichen Leuchtdiodenchips 81 umfassen. Das Leuchtmittel umfasst einen Gehäusekörper 5, der vorliegend mit einem reflektierendem Metall oder einem reflektierend beschichteten Kunststoff gebildet sein kann. Der Gehäusekörper 5 umschließt ein Volumen 51, in dem die Leuchtdiodenanordnung 7 mit dem Piezo-Transformator 1 vollständig angeordnet ist.

Das Leuchtmittel umfasst ferner einen Sockel 6, mit Sockelkontakten 61, über die das Leuchtmittel von außerhalb mit Strom und Spannung versorgt werden kann. Vorliegend ist der Sockel 6 als Stecksockel ausgebildet.

Im Beispiel der Figur 4A, das nicht Teil der Erfindung ist, ist der Piezo-Transformator an einer dem Anschlussträger 3 abgewandten Seite des Kühlkörpers 4 angeordnet. Der Piezo-Transformator 1 ist damit zwischen dem Sockel 6 und dem Anschlussträger 3 angeordnet. Zur elektrischen Isolation der Sockelkontakte 61 sowie der elektrischen Verbindungen 62, die durch den Kühlkörper 4 hindurch zum Anschlussträger 3 reichen, ist zwischen Sockel 6 und Piezo-Transformator 1 eine elektrische Isolierung 52 angeordnet.

Der Piezo-Transformator 1 ist über ein Mittel zur mechanischen Entkopplung 13 - zum Beispiel über ein Elastomer - schwingend am Gehäusekörper 5 befestigt.

Der Kühlkörper 4 nimmt in diesem Ausführungsbeispiel einen besonders großen Anteil des Volumens 51, das vom Gehäusekörper 5 umschlossen ist ein. Vorliegend nimmt der Kühlkörper 4 zirka ein Drittel des umschlossenen Volumens 51 ein.

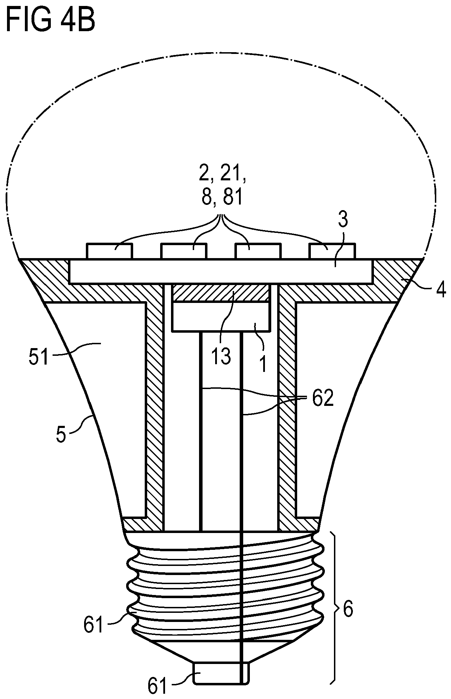

In Verbindung mit der Figur 4B ist anhand einer schematischen Schnittdarstellung ein weiteres Beispiel eines hier beschriebenen Leuchtmittels erläutert, das nicht Teil der Erfindung ist.

In diesem Ausführungsbeispiel ist der Sockel 6 als Schraubsockel ausgebildet. Der Piezo-Transformator 1 ist an der den Leuchtdioden 2, 8 abgewandten Seite des Anschlussträger 3 schwingungsgedämpft an diesem befestigt. Der Piezo-Transformator 1 ist von Kühlrippen 41 des Kühlkörpers seitlich umgeben. Die Kühlrippen 41 des Kühlkörpers 4 können auf diese Weise besonders weit in das Gehäuse 5 ragen, so dass sie einen großen Teil des Volumens 51 einnehmen. Somit wird der Wärmeaustausch mit der Umgebungsluft maximiert.

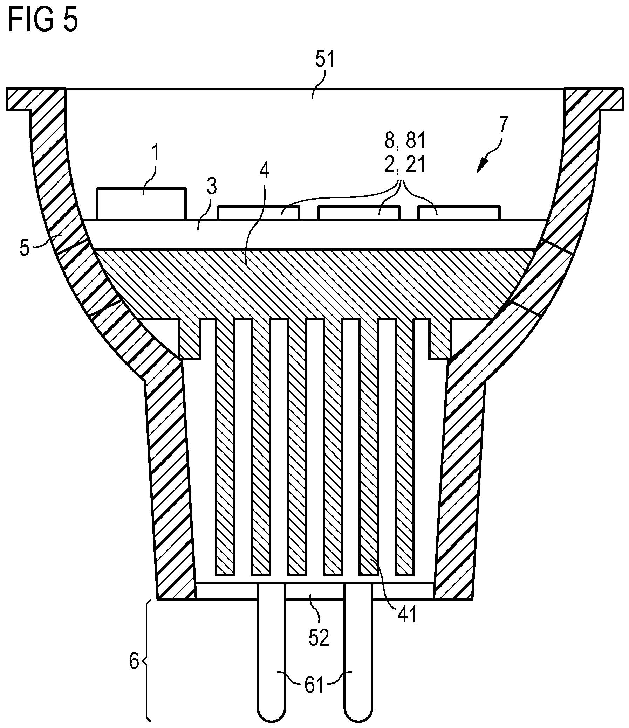

In Verbindung mit der Figur 5 ist anhand einer schematischen Schnittdarstellung ein weiteres Beispiel eines hier beschriebenen Leuchtmittels erläutert, das nicht Teil der Erfindung ist. In diesem Beispiel ist der Piezo-Transformator gemeinsam mit den Leuchtdioden 2, 8 auf der Montagefläche 3a des Anschlussträgers 3 angeordnet und elektrisch angeschlossen. Der Kühlkörper 4 befindet sich an der der Montagefläche 3a abgewandten Seite des Anschlussträgers 3. Kühlrippen 41 des Kühlkörpers 4 ragen in das umschlossene Volumen 51. Vorliegend nimmt der Kühlkörper 4 über 50 % des Volumens 51, das vom Gehäusekörper 5 umschlossen ist, ein. Ein solches Leuchtmittel erweist sich hinsichtlich seiner thermischen Eigenschaften als besonders vorteilhaft.

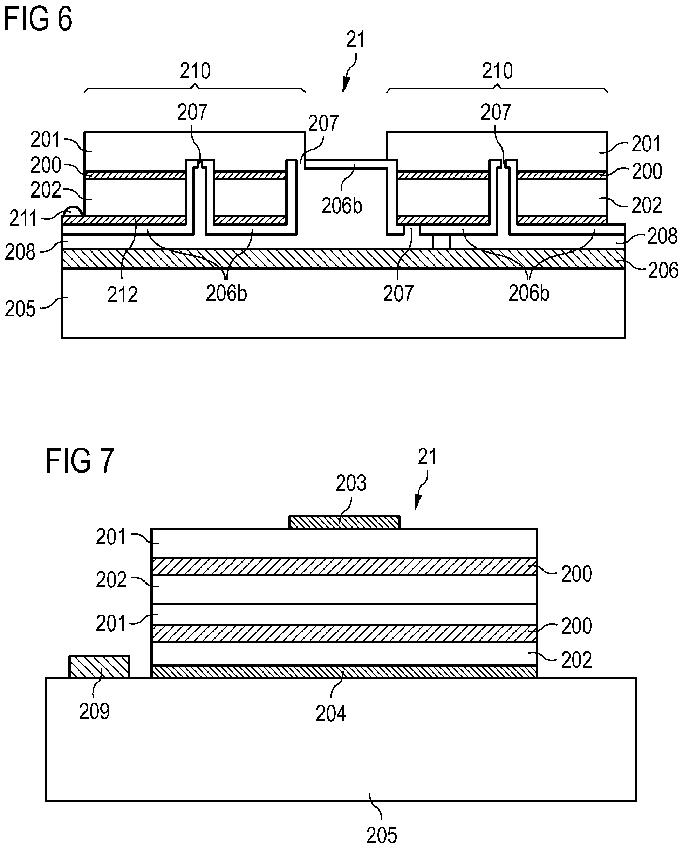

In Verbindung mit der schematischen Schnittdarstellung der Figur 6 ist eine Hochvolt-Leuchtdiode 21 näher erläutert, wie sie in hier beschriebenen Leuchtdiodenanordnungen und Leuchtmitteln zum Einsatz kommen kann. Die Hochvolt-Leuchtdiode 21 umfasst einen Träger 205, der beispielsweise mit einem elektrisch leitenden oder einem elektrisch isolierenden Material gebildet sein kann. Falls der Träger elektrisch leitend ist, ist eine Isolierschicht 206a auf dem Träger 205 angeordnet.

Auf dem Träger 205 ist eine Kontaktschicht 208 aufgebracht, die zur Kontaktierung von aktiven Bereichen 200, die zur Strahlungserzeugung vorgesehen sind, dient. Die Kontaktschicht 208 ist zumindest stellenweise von einer Isolierschicht 206b bedeckt, die beispielsweise mit Siliziumdioxid gebildet ist. Die Isolierschicht 206b weist Öffnungen 207 auf, in denen ein elektrisch leitender Kontakt zwischen der Kontaktschicht 208 und den aktiven Bereichen 200 ermöglicht ist.

Der Hochvolt-Leuchtdiodenchip 21 gliedert sich dabei in wenigstens zwei und höchstens n=(U_{Netz} √ 2 / U_{f}) Pixel 210. U_{Netz} ist dabei die Netzspannung und U_{f} ist die Vorwärtsspannung, die an einem aktiven Bereich 200 des Hochvolt-Leuchtdiodenchips abfällt.

Jedes Pixel 210 umfasst eine p-Kontaktschicht 212, die zwischen der Isolierschicht 206b und dem p-leitenden Bereich 202 angeordnet ist. An der p-Kontaktschicht 212 ist der p-seitige Anschluss 211 des Hochvolt-Leuchtdiodenchips 21 elektrisch angeschlossen. Somit werden beide Ladungsträgersorten von der Emissionsseite des Hochvolt-Leuchtdiodenchips abgewandten Seite aus lateral, also über die aktiven Bereiche 200 verteilt - und den jeweiligen leitenden Bereichen 201, 202 zugeführt.

Die Pixel sind vorliegend in Reihe geschaltet, wobei der p-leitende Bereich 202 eines Pixels 210 mit dem n-leitenden Bereich 201 eines benachbarten Pixels elektrisch leitend verbunden ist.

Im Ausführungsbeispiel der Figur 6 sind die Pixel 210 und damit die aktiven Bereiche 200 der Hochvolt-Leuchtdiode lateral benachbart zueinander angeordnet.

In Verbindung mit der Figur 7 ist eine alternative Ausführung einer Hochvolt-Leuchtdiode, wie sie vorliegend zum Einsatz kommen kann, beschrieben. In diesem Ausführungsbeispiel sind die aktiven Bereiche 200, die zueinander in Reihe geschaltet sind, vertikal übereinander gestapelt angeordnet. In den aktiven Bereichen 200 kann elektromagnetische Strahlung mit gleichen oder unterschiedlichen Wellenlängen erzeugt werden. Zwischen der n-leitenden Schicht 201 und der p-leitenden Schicht 202, die im Hochvolt-Leuchtdiodenchip 21 aneinander grenzen, kann ein Tunnelkontakt angeordnet sein.

Neben den Halbleiterschichten des Hochvolt-Leuchtdiodenchips 21 ist im Ausführungsbeispiel der Figur 7 ein Vorwiderstand 209 auf dem Träger 204 angeordnet. Ein Hochvolt-Leuchtdiodenchip wie er in der Figur 7 beschrieben ist, ist in einem anderen Zusammenhang beispielsweise auch in der Druckschrift WO 2008/040300 A1 angegeben, die vorliegend ausdrücklich per Rückbezug aufgenommen ist.

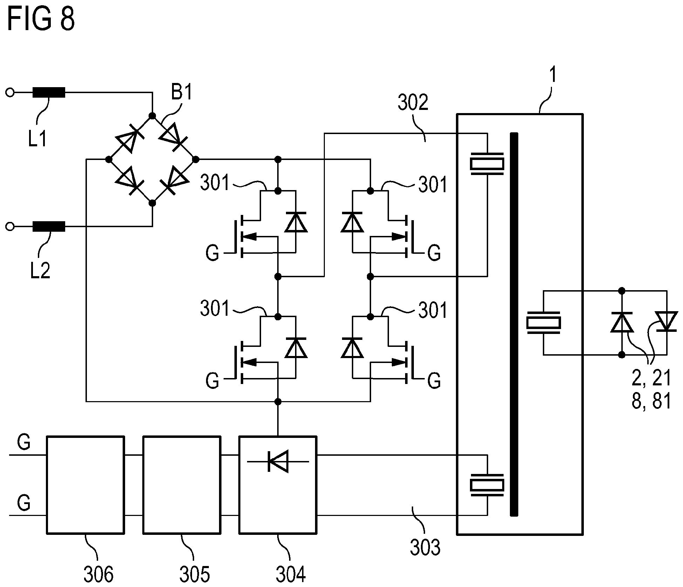

Die Figur 8 zeigt eine schematische Schaltskizze einer hier beschriebenen Leuchtdiodenanordnung. Die Leuchtdiodenanordnung der Figur 8 umfasst folgende Komponenten: Induktivitäten L1, L2, einen Gleichrichter B1, Feldeffekttransistoren 301, einen Versorgungseingang 302, den Piezo-Transformator 1, die Leuchtdioden beziehungsweise Leuchtdiodenchips 2, 21, 8, 81 der Leuchtdiodenanordnung, einen Hilfsausgang 303, einen Gleichrichter und Tiefpassfilter (rectifier, low pass filter) 304, einen Maximumdetektor 305 und einen spannungsgesteuerten Oszillator (VCO - voltage controlled oszillator) 306. Um den Piezotransformator 1 beispielsweise in das hier beschriebene Leuchtmittel zu integrieren kann eine Frequenz-gebende Transistorschaltung eingesetzt werden. Zur Erhaltung der maximalen Effizienz des Piezo-Transformators 1 bei schwankenden Temperaturen, beispielsweise aufgrund der Abwärme der Leuchtdioden des Leuchtmittels, kann an eine oder alle ausgangsseitigen Anschlussstellen des Piezo-Transformators 1 ein Feedbackelement verbunden sein, welches der Transistorschaltung zur Optimierung der Betriebsfrequenz die Ausgangsleistung des Piezo-Transformators 1 rückkoppelt.

Der spannungsgesteuerte Oszillator 306 der in der Figur 8 gezeigten Schaltung kann die Frequenzen in Abhängigkeit von der Eingangsspannung verändern. Der spannungsgesteuerte Oszillator 306 ist dabei so ausgelegt, dass mindestens der Frequenzresonanzbereich über alle Temperaturen und Lasten angesteuert werden kann. Beispielsweise direkt an den spannungsgesteuerten Oszillator 306 ist der Maximumdetektor 305 angeschlossen.

Der Maximumdetektor 305 ist ein Regler, der das Signal für den spannungsgesteuerten Oszillator 306 derart regelt, dass die Spannung am Ausgang der nachfolgenden Komponente Gleichrichter und Tiefpassfilter 304 immer das mögliche Maximum, also das Maximum der Energieübertragung, erreicht.

Beispielsweise direkt an den Maximumdetektor ist der Gleichrichter und Tiefpassfilter 304 angeschlossen. Diese Komponente erzeugt ein Signal proportional zum Spitzenwert der übertragenen Leistung am Hilfsausgang 303 des Piezo-Transformators 1.

Am Versorgungseingang 302 bilden die Feldeffekttransistoren 301 eine Leistungsstufe zur Ansteuerung der Primärseite des Piezo-Transformators 1. Dabei ist es möglich, diese Ansteuerung alternativ, beispielsweise mit einem Transistor auszuführen.

Diese Patentanmeldung beansprucht die Priorität der deutschen Patentanmeldung 102010023342.0.

Die Erfindung ist nicht durch die Beschreibung anhand der Ausführungsbeispiele auf diese beschränkt.

## Patentansprüche

1. Leuchtdiodenanordnung mit
- einem Piezo-Transformator (1), der eine ausgangseitige Anschlussstelle (11) aufweist, und
- einer Hochvolt-Leuchtdiode (2), die einen Hochvolt-Leuchtdiodenchip (21) umfasst, wobei
- die Hochvolt-Leuchtdiode (2) elektrisch an die ausgangseitige Anschlussstelle (11) des Piezo-Transformators (1) angeschlossen ist, **dadurch gekennzeichnet, dass**
- der Hochvolt-Leuchtdiodenchip (21) zumindest zwei aktive Bereiche (200) umfasst, die zueinander in Reihe geschaltet sind,
- der Piezo-Transformator (1) rahmenartig ausgebildet ist, und
- der Piezo-Transformator (1) die Hochvolt-Leuchtdiode (2) seitlich umschließt.

2. Leuchtdiodenanordnung gemäß dem vorherigen Anspruch, bei der die Hochvolt-Leuchtdiode (2) mehr als einen Hochvolt-Leuchtdiodenchip (21) umfasst, wobei jeder Hochvolt-Leuchtdiodenchip (21) zumindest zwei aktive Bereiche (200) umfasst, die zueinander in Reihe geschaltet sind.

3. Leuchtdiodenanordnung gemäß Anspruch 1, bei der die Hochvolt-Leuchtdiode (2) oder der Hochvolt-Leuchtdiodenchip (21) mit Wechselspannung betreibbar ist.

4. Leuchtdiodenanordnung gemäß einem der vorherigen Ansprüche mit
- einem Anschlussträger (3) der eine Montagefläche (3a) aufweist, wobei
- die Hochvolt-Leuchtdiode (2) an der Montagefläche (3a) befestigt und elektrisch leitend mit dem Anschlussträger (3) verbunden ist,
- der Piezo-Transformator (1) mit dem Anschlussträger (3) elektrisch leitend verbunden ist, und
- die Hochvolt-Leuchtdiode (2) über den Anschlussträger (3) an die ausgangseitige Anschlussstelle (11) des Piezo-Transformators (1) angeschlossen ist.

5. Leuchtdiodenanordnung mit
- einem Piezo-Transformator (1), der mehrere ausgangseitige Anschlussstellen (11) aufweist, und
- mehrere Hochvolt-Leuchtdioden (2), wobei jede Hochvolt-Leuchtdiode (2) einen Hochvolt-Leuchtdiodenchip (21) umfasst, wobei
- an jeder ausgangseitigen Anschlussstelle (11) des Piezo-Transformators (1) jeweils wenigstens eine der Hochvolt-Leuchtdioden (2) elektrisch angeschlossen ist, **dadurch gekennzeichnet, dass**
- jeder Hochvolt-Leuchtdiodenchip (21) zumindest zwei aktive Bereiche (200) umfasst, die zueinander in Reihe geschaltet sind,
- der Piezo-Transformator (1) rahmenartig ausgebildet ist, und
- der Piezo-Transformator (1) die Hochvolt-Leuchtdioden (2) seitlich umschließt.

6. Leuchtmittel mit
- zumindest einer Leuchtdiodenanordnung (7) gemäß den Ansprüchen 1 bis 4,
- einem Gehäusekörper (5), der ein Volumen (51) umschließt, in dem die Leuchtdiodenanordnung (7) vollständig angeordnet ist, und
- einem Sockel (6), der einen Sockelkontakt (61) umfasst, wobei
- der Piezo-Transformator (1) eine eingangsseitige Anschlussstelle (12) umfasst, und
- die eingangsseitige Anschlussstelle (12) des Piezo-Transformators (1) mit dem Sockelkontakt (61) elektrisch leitend verbunden ist.

7. Leuchtmittel nach Anspruch 6 mit
- einem Kühlkörper (4), der thermisch leitend mit der zumindest einen Leuchtdiodenanordnung (7) verbunden ist, wobei
- der Kühlköper (4) vollständig im vom Gehäusekörper (5) umschlossenen Volumen (51) angeordnet ist, und
- der Kühlkörper (4) wenigstens 20 % des Volumens (51) ausfüllt.

## Claims

1. Light-emitting diode arrangement, having
- a piezo transformer (1), which has an output-side connection point (11), and
- a high-voltage light-emitting diode (2), which comprises a high-voltage light-emitting diode chip (21), wherein
- the high-voltage light-emitting diode (2) is electrically connected to the output-side connection point (11)of the piezo transformer (1), **characterized in that**
- the high-voltage light-emitting diode chip (21) comprises at least two active regions (200), which are connected in series with one another,
- the piezo transformer (1) is formed frame-like, and
- the piezo transformer (1) laterally encloses the high-voltage light-emitting diode (2).

2. Light-emitting diode arrangement according to the preceding claim, in which
the high-voltage light-emitting diode (2) comprises more than one high-voltage light-emitting diode chip (21), wherein each high-voltage light-emitting diode chip (21) comprises at least two active regions (200), which are connected in series with one another.

3. Light-emitting diode arrangement according to claim 1, in which
the high-voltage light-emitting diode (2) or the high-voltage light-emitting diode chip (21) is operable with alternating voltage.

4. Light-emitting diode arrangement according to one of the preceding claims, having
- a connection carrier (3), which has a mounting surface (3a), wherein
- the high-voltage light-emitting diode (2) is fixed to the mounting surface (3a) and is electrically conductively connected to the connection carrier (3),
- the piezo transformer (1) is electrically conductively connected to the connection carrier (3), and
- the high-voltage light-emitting diode (2) is connected via the connection carrier (3) to the output-side connection point (11) of the piezo transformer (1).

5. Light-emitting diode arrangement, having
- a piezo transformer (1), which has a plurality of output-side connection points (11), and
- a plurality of high-voltage light-emitting diodes (2), wherein each high-voltage light-emitting diode (2) comprises a high-voltage light-emitting diode chip (21), wherein
- at each output-side connection point (11) of the piezo transformer (1) at least one of the high-voltage light-emitting diodes (2) is electrically connected in each case, **characterized in that**
- each high-voltage light-emitting diode chip (21) comprises at least two active regions (200), which are connected in series with respect to one another,
- the piezo transformer (1) is formed frame-like, and
- the piezo transformer (1) laterally encloses the high-voltage light-emitting diodes (2).

6. Luminous means, having
- at least one light-emitting diode arrangement (7) according to claims 1 to 4,
- a housing body (5), which encloses a volume (51), in which the light-emitting diode arrangement (7) is completely arranged, and
- a base (6), which comprises a base contact (61), wherein
- the piezo transformer (1) comprises an input-side connection point (12), and
- the input-side connection point (12) of the piezo transformer (1) is electrically conductively connected to the base contact (61).

7. Luminous means according to claim 6, having
- a heat sink (4), which is connected in a thermally conductive manner to the at least one light-emitting diode arrangement (7), wherein
- the heat sink (4) is arranged completely in the volume enclosed by the housing body (5), and
- the heat sink (4) fills at least 20% of the volume (51).

## Revendications

1. Agencement de diodes électroluminescentes comprenant
- un transformateur piézoélectrique (1) qui présente un point de raccordement (11) côté sortie, et
- une diode électroluminescente à haut voltage (2), qui comprend une puce à diode électroluminescente à haut voltage (21),
- la diode électroluminescente à haut voltage (2) étant électriquement raccordée au point de raccordement (11), côté sortie, du transformateur piézoélectrique (1), **caractérisé en ce que**
- la puce à diode électroluminescente à haut voltage (21) comprend au moins deux zones actives (200) qui sont connectées en série l'une par rapport à l'autre,
- le transformateur piézoélectrique est formé en forme de cadre,
- le transformateur piézoélectrique (1) entoure latéralement la diode électroluminescente à haut voltage (2) .

2. Agencement de diodes électroluminescentes selon la revendication précédente, dans lequel la diode électroluminescente à haut voltage (2) comprend plus d'une puce à diode électroluminescente (21), chaque puce à diode électroluminescente à haut voltage (21) comprenant au moins deux zones actives (200) qui sont connectées en série l'une par rapport à l'autre.

3. Agencement de diodes électroluminescentes selon la revendication 1, dans lequel la diode électroluminescente à haut voltage (2) ou la puce à diode électroluminescente à haut voltage (21) est exploitable avec une tension alternative.

4. Agencement de diodes électroluminescentes selon l'une quelconque des revendications précédentes, comprenant
- un support de raccordement (3) qui présente une surface de montage (3a),
- la diode électroluminescente à haut voltage (2) étant fixée sur la surface de montage (3a) et étant reliée au support de raccordement (3) de manière électro-conductrice,
- le transformateur piézoélectrique (1) étant relié au support de raccordement (3) de manière électro-conductrice, et
- la diode électroluminescente à haut voltage (2) étant raccordée au point de raccordement (11), côté sortie, du transformateur piézoélectrique (1) par l'intermédiaire du support de raccordement (3).

5. Agencement de diodes électroluminescentes comprenant
- un transformateur piézoélectrique (1) qui présente plusieurs points de raccordement (11) côté sortie, et
- plusieurs diodes électroluminescentes à haut voltage (2), chaque diode électroluminescente à haut voltage (2) comprenant une puce à diode électroluminescente à haut voltage (21),
- au moins une des diodes électroluminescentes à haut voltage (2) étant respectivement électriquement raccordée à chaque point de raccordement (11), côté sortie, du transformateur piézoélectrique (11), **caractérisé en ce que**
- chaque puce à diode électroluminescente à haut voltage (21) comprend au moins deux zones actives (200) qui sont connectées en série l'une par rapport à l'autre,
- le transformateur piézoélectrique (21) est formé en forme de cadre, et
- le transformateur piézoélectrique (1) entoure latéralement les diodes électroluminescentes à haut voltage (2).

6. Moyens lumineux, comprenant
- au moins un agencement de diodes électroluminescentes (7) selon les revendications 1 à 4,
- un corps de boîtier (5) qui entoure un volume (51) dans lequel l'agencement de diodes électroluminescentes (7) est entièrement disposé, et
- un socle (6) qui comprend un contact de socle (61),
- le transformateur piézoélectrique (1) comprenant un point de raccordement (12) côté entrée, et
- le point de raccordement (12), côté entrée, du transformateur piézoélectrique (1) étant raccordé au contact de socle (61) de manière électro-conductrice.

7. Moyens lumineux selon la revendication 6, comprenant
- un corps de refroidissement (4) qui est relié à l'au moins un agencement de diodes électroluminescentes de manière thermiquement conductrice,
- le corps de refroidissement (4) étant entièrement disposé dans le volume (51) entouré par le corps de boîtier (5), et
- le corps de refroidissement (4) remplissant au moins 20% du volume (51).
